# EUROPÄISCHE PATENTSCHRIFT

(11) **EP 3 043 220 B1**
(45) Veröffentlichungstag und Bekanntmachung des Hinweises auf die Patenterteilung: **11.10.2017**
(21) Anmeldenummer: 15200414.9
(22) Anmeldetag: 16.12.2015
(51) Int. Cl.: G05B 19/042, G05B 9/02

(54) **VORRICHTUNG UND VERFAHREN ZUR FUNKTIONSÜBERWACHUNG EINES SICHERHEITSSCHALTMITTELS**
DEVICE AND METHOD FOR MONITORING THE FUNCTION OF A SAFETY SWITCHING DEVICE
DISPOSITIF ET PROCEDE DE SURVEILLANCE FONCTIONNELLE D'UN MOYEN DE COMMUTATION DE SECURITE

(30) Priorität: 07.01.2015 DE 102015200057
(43) Veröffentlichungstag der Anmeldung: 13.07.2016
(73) Patentinhaber: Wago Verwaltungsgesellschaft mbH, 32423 Minden (DE)
(72) Erfinder: VOß, Christian, 32427 Minden (DE)
(74) Vertreter: Hohgardt, Martin

(56) Entgegenhaltungen:
- EP-A1- 2 149 826
- WO-A2-02/071600
- DE-A1- 19 508 841
- US-A1- 2008 007 879

## Beschreibung

### 1. Gebiet der Erfindung

Die vorliegende Erfindung betrifft eine Vorrichtung und ein Verfahren zur Funktionsüberwachung eines Sicherheitsschaltmittels, wobei das Sicherheitsschaltmittel insbesondere zum Schalten eines Aktuators verwendet werden kann.

### 2. Stand der Technik

Sicherheitsschaltungen mit Sicherheitsschaltmitteln kommen für das Schalten von sicherheitsrelevanten Aktuatoren zum Einsatz, wie beispielsweise einem Antriebsmotor, der über ein Motorschütz geschaltet wird. WO 02/071600 A2 zeigt ein Beispiel einer Sicherheitsschaltung. Zur Überwachung des Betriebszustands des Aktuators können Sicherheitsschaltungen die Rückmeldungssignale des Aktuators, beispielsweise über einen Hilfskontakt des Schützes, verwenden. Im Falle einer Störung, wenn das aktuelle Schaltsignal nicht mit dem Rückmeldungssignal übereinstimmt, bewirkt eine derartige Sicherheitsschaltung, dass der Aktuator mittels des Sicherheitsschaltmittels sicher vom Netz genommen wird. Abhängig von der geforderten Sicherheitsstufe können die Sicherheitsschaltungen auch redundant ausgeführt sein.

Die Funktionsfähigkeit des Sicherheitsschaltmittels ist daher zu jedem Zeitpunkt sicherzustellen. Bevorzugt finden Halbleiterschalter als Sicherheitsschaltmittel Verwendung, weil dadurch der Einsatz von Metallkontakten, die sich abnutzen, oxidieren oder auch verkleben können, vermieden werden kann. Für das Testen der Funktionsfähigkeit wird der Schaltzustand des Sicherheitsschaltmittels in regelmäßigen Zeitabständen geändert, um das einwandfreie Schalten des Sicherheitsschaltmittels überprüfen zu können. Nachdem die einwandfreie Funktionsfähigkeit des Sicherheitsschaltmittels festgestellt wurde, wird die Änderung des Schaltzustands des Sicherheitsschaltmittels wieder rückgängig gemacht. Der zeitliche Abstand zwischen den zwei Schaltvorgängen sollte relativ kurz sein. Auf jeden Fall muss der zeitliche Abstand so kurz sein, dass aufgrund der Trägheit des Aktuators der Betriebszustand des Aktuators nicht geändert wird, um ein versehentliches Abschalten des Aktuators zu verhindern.

Im Stand der Technik wird üblicherweise die Funktionsüberwachung des Sicherheitsschaltmittels mittels einer programmierbaren Logik getestet, wie zum Beispiel in US 2008/0007879 A1 beschrieben. Hierzu wird von der programmierbaren Logik ein Testsignal erzeugt, das den Schaltzustand des Sicherheitsschaltmittels ändert. Nach dem erfolgreichen Erkennen der Abschaltung über einen Überwachungseingang schaltet die programmierbare Logik das Sicherheitsschaltmittel wieder ein.

Wie zum Beispiel in DE 195 08 841 A1 beschrieben, kann eine Rechnereinheit den Schaltzustand des Sicherheitsschaltmittels für die Länge eines Testimpulses ändern. Die Länge des Testimpulses richtet sich idealerweise nach der Trägheit des zu schaltenden Aktuators, so dass der Betriebszustand des Aktuators während des Tests nicht geändert wird. Die erfolgreiche Änderung des Schaltzustands wird während dem Test an einem Eingang der Rechnereinheit angezeigt.

In EP 2 149 826 B1 wird die Funktionsüberwachung mit Hilfe einer programmierbaren Logik beschrieben, wobei die programmierbare Logik ein einfaches Anpassen der Funktionsüberwachung an das zu testende Sicherheitsschaltmittel und den verwendeten Aktuator ermöglicht.

Derartige Funktionsüberwachungen haben allerdings den Nachteil, dass die verwendeten programmierbaren Logiken, wie beispielsweise Mikrocontroller oder Recheneinheiten hinreichend schnell sein müssen, um die erfolgreiche Änderung des Schaltzustands an dem entsprechenden Eingang der programmierbaren Logik erkennen zu können, da das zugehörige Signal dort nur für eine kurze Dauer anliegt. Daher können ausschließlich sehr hochgetaktete programmierbare Logiken für die Funktionsüberwachung verwendet werden, da nur diese programmierbaren Logiken den Geschwindigkeitsanforderungen entsprechen. Allerdings sind solche programmierbaren Logiken vergleichsweise teuer. Weiterhin haben derartige Funktionsüberwachungen den Nachteil, dass die Abschaltzeit von der Geschwindigkeit und Softwarearchitektur der programmierbaren Logik abhängt und die Dauer des Testsignals bzw. des Testimpulses gegebenenfalls manuell an die Trägheit der zu schaltenden Komponente angepasst werden muss.

Die Aufgabe der vorliegenden Erfindung ist daher, eine Vorrichtung zur Funktionsüberwachung eines Sicherheitsschaltmittels bereitzustellen, die günstig in der Herstellung ist, unabhängig von der Geschwindigkeit der programmierbaren Logik ist und die unabhängig von der Trägheit der zu schaltenden Komponente ein verlässliches Ergebnis liefert.

### 3. Zusammenfassung der Erfindung

Diese Aufgabe wird erfindungsgemäß durch die Vorrichtung zur Funktionsüberwachung gemäß Anspruch 1 und das Verfahren zur Funktionsüberwachung gemäß Anspruch 15 gelöst.

Die erfindungsgemäße Vorrichtung wird zur Funktionsüberwachung eines Sicherheitsschaltmittels verwendet, welches insbesondere zum Schalten eines Aktuators verwendet werden kann. Ein derartiges Sicherheitsschaltmittel weist einen Betätigungseingang und einen Schaltausgang auf. Die erfindungsgemäße Vorrichtung weist ein Betätigungsmittel und ein Auswertemittel auf. Das Betätigungsmittel weist einen Steuereingang, einen Testeingang, einen Rückmeldungseingang und einen Betätigungsausgang zur Verbindung mit dem Betätigungseingang des Sicherheitsschaltmittels auf. Das Auswertemittel weist einen Überwachungseingang zur Verbindung mit dem Schaltausgang des Sicherheitsschaltmittels, einen Funktionsmeldeausgang und einen Rückmeldungsausgang auf. Das Betätigungsmittel ist derart ausgestaltet, dass es für einen Funktionstest des Sicherheitsschaltmittels ein Signal an dem Betätigungsausgang in Abhängigkeit von den Signalen an dem Testeingang und dem Steuereingang ändert. Das Auswertemittel ist derart ausgestaltet, dass es über den Überwachungseingang eine Änderung eines Signals an dem Schaltausgang des Sicherheitsschaltmittels erkennt und insbesondere bei einem Funktionstest ein Signal mit einer Information über die Änderung über den Rückmeldungsausgang des Auswertemittels an den Rückmeldungseingang des Betätigungsmittels weiterleitet und ein Signal mit einer Information über die Änderung an dem Funktionsmeldeausgang bereitstellt. Außerdem ist das Betätigungsmittel derart ausgestaltet, dass bei einem Funktionstest im Falle des Erhalts eines Signals mit einer Information über die Änderung des Signals an dem Schaltausgang des Sicherheitsschaltmittels, umgehend die Signaländerung an dem Betätigungsausgang rückgängig gemacht wird.

Mit Hilfe dieser erfindungsgemäßen Vorrichtung kann die Funktion von Sicherheitsschaltmitteln erstmals zuverlässig und günstig überwacht werden. Darüber hinaus stellt die erfindungsgemäße Vorrichtung erstmals eine universell einsetzbare Funktionsüberwachung bereit, da die Vorrichtung unabhängig von der zu schaltenden Komponente eingesetzt werden kann.

Die erfindungsgemäße Vorrichtung wird beispielhaft im Zusammenhang mit einem Sicherheitsschaltmittel zum Schalten eines Aktuators beschrieben. Die gleichen Vorteile können aber auch bei Schalten anderer Elemente erzielt werden.

Derartige Sicherheitsschaltmittel weisen einen Betätigungseingang und einen Schaltausgang auf. Der Betätigungseingang ist der Eingang des Sicherheitsschaltmittels über den das Sicherheitsschaltmittel ein Signal mit der Information erhält, dass es schalten soll. Im Rahmen der Erfindung beschreibt ein Signal etwas mit dem eine Information übermittelt werden kann. Die Information kann beispielsweise durch ein analoges oder ein digitales Signal übermittelt werden. Die Information kann auch dadurch übermittelt werden, dass entweder ein Signal oder kein Signal übermittelt wird. Der Schaltzustand des Sicherheitsschaltmittels wirkt sich auf den Schaltausgang des Sicherheitsschaltmittels aus. Beispielsweise kann das Sicherheitsschaltmittel noch einen weiteren Eingang aufweisen, an dem eine Betriebsspannung anliegt. In Abhängigkeit von dem Schaltzustand des Sicherheitsschaltmittels liegt diese Betriebsspannung an dem Schaltausgang und somit auch an dem mit dem Schaltausgang verbundenen Aktuator an oder nicht.

Das Betätigungsmittel der erfindungsgemäßen Vorrichtung weist einen Testeingang auf. Hierbei handelt es sich um einen Eingang über den das Betätigungsmittel ein Signal mit einer Information über beziehungsweise für den Funktionstest erhält. Ein an diesem Eingang anliegendes Signal kann beispielsweise anzeigen, dass bei einer fallenden Flanke am Steuereingang ein Funktionstest durchgeführt werden soll. Das Betätigungsmittel weist außerdem einen Betätigungsausgang auf. Dieser Betätigungsausgang steht während der Funktionsüberwachung in Verbindung mit dem Betätigungseingang des Sicherheitsschaltmittels. Mit Hilfe eines über den Betätigungsausgang bereit gestellten Signals kann das Sicherheitsschaltmittel betätigt werden, d.h. es kann geschaltet werden. Darüber hinaus weist das Betätigungsmittel noch einen Rückmeldungseingang auf, der weiter unten erläutert wird.

Im Rahmen der Funktionsüberwachung kann mittels des Betätigungsmittels der erfindungsgemäßen Vorrichtung ein Signal an dem Betätigungsausgang verändert werden. Der Zweck dieser Signaländerung ist es für einen Funktionstest den Schaltzustand des Sicherheitsschaltmittels, das über seinen Betätigungseingang mit dem Betätigungsausgang des Betätigungsmittels verbunden ist, zu verändern. Erfindungsgemäß ändert das Betätigungsmittel das Signal an dem Betätigungsausgang in Abhängigkeit von einer Änderung der Signale an dem Steuereingang und dem Testeingang. Wie bereits oben erläutert, kann es sich bei dem Signal an dem Testeingang beispielsweise um ein Signal handeln, das die Durchführung eines Funktionstests anzeigt. Beispielsweise wird zunächst als Vorbereitung für den Test das Signal an dem Testeingang geändert. Danach wird der Test durch eine Änderung des Signals an dem Steuereingang eingeleitet.

Ein Beispiel für die Änderung eines Signals ist der Wechsel von einem logischen Low-Pegel zu einem logischen High-Pegel oder andersherum. Der Low-Pegel kann auch als logisches "0" Signal bezeichnet werden und der High-Pegel als logisches "1" Signal. Grundsätzlich ist aber jede Signaländerung umfasst, die von dem Empfänger als Änderung erkannt werden kann. Insbesondere sind Signaländerungen umfasst, durch die sich die von dem Signal übermittelte Information ändert.

Das Auswertemittel der erfindungsgemäßen Vorrichtung weist einen Überwachungseingang zur Verbindung mit dem Schaltausgang des Sicherheitsschaltmittels auf. Außerdem weist das Auswertemittel einem Funktionsmeldeausgang und einem Rückmeldungsausgang auf.

Der Überwachungseingang des Auswertemittels erkennt eine Änderung eines Signals an dem Schaltausgang des Sicherheitsschaltmittels. Hierfür kann der Überwachungseingang beispielsweise an der Verbindung zwischen dem Sicherheitsschaltmittel und dem Aktuator angeschlossen sein.

Der Rückmeldungsausgang des Auswertemittels steht über eine Rückmeldungsverbindung in Verbindung mit dem Rückmeldungseingang des Betätigungsmittels. Im Rahmen der Erfindung stellt das Auswertemittel dem Betätigungsmittel über diese Verbindung ein Signal mit einer Information über die Änderung eines Signals an dem Schaltausgang des Sicherheitsmittels bereit. Dies hat den Vorteil, dass das Betätigungsmittel sofort nach einer erkannten Schaltzustandsänderung des Sicherheitsschaltmittels, den Schaltzustand wieder ändern kann. Das Signal mit der Information über die Änderung des Signals an dem Schaltausgang des Sicherheitsschaltmittels kann auf viele verschiedene Arten an den Rückmeldungseingang des Betätigungsmittels übermittelt werden. Vorzugsweise ändert sich ein Signal an dem Rückmeldungseingang des Betätigungsmittels, wenn eine Änderung des Signals an dem Schaltausgang des Sicherheitsschaltmittels festgestellt wurde.

Über den Funktionsmeldeausgang stellt das Auswertemittel auch ein Signal mit einer Information über die Änderung des Signals an dem Schaltausgang bereit. Hierbei kann es sich beispielsweise um eine Anzeige handeln, dass das Sicherheitsschaltmittel ordnungsgemäß funktioniert. Dieses Signal mit dieser Information kann aber auch an andere Mittel weitergeleitet werden, wie weiter unten beschrieben wird.

Grundsätzlich kann das Sicherheitsschaltmittel den Energieversorgungseingang des Aktuators gegen die positive Versorgungsspannung und/oder den Energieversorgungsausgang des Aktuators gegen Masse schalten. In einer bevorzugten Ausführungsform kann das Sicherheitsschaltmittel den Aktuator sowohl gegen die positive Versorgungsspannung als auch gegen die Masse schalten. Beispielsweise kann die erfindungsgemäße Funktionsüberwachung redundant aufgebaut sein, d.h. mit Hilfe von zwei Sicherheitsschaltern wird ein Aktuator gegen die Versorgungsspannung und gegen Masse geschaltet, wie es beispielsweise in der Norm EN ISO 13849 für Sicherheitsschaltanordnungen der höchsten Sicherheitsstufe verlangt wird.

In einer weiteren bevorzugten Ausführungsform ist das Sicherheitsschaltmittel ein Halbleiterschalter. Halbleiterschalter haben im Gegensatz zu mechanischen Relais keine mechanischen Kontakte und schnellere Schaltzeiten. Weiterhin unterliegen Halbleiterschalter einer geringeren Alterung als vergleichbare Schalter mit mechanischen Kontakten. Im Rahmen der vorliegenden Erfindung könnte allerdings auch ein Relais als Sicherheitsschaltmittel verwendet werden, zum Beispiel wenn die Verwendung eines Relais von einer Norm für die Funktionsüberwachung des Sicherheitsschaltmittels vorgeschrieben ist.

In einer bevorzugten Ausführungsform ist das Betätigungsmittel ausgestaltet das Signal am Betätigungsausgang so lange zu ändern, wie sich das Signal an dem Testeingang und das Signal an dem Rückmeldungseingang des Betätigungsmittels nicht ändern. Durch das Ändern des Signals an dem Betätigungsausgang wird der Zustand des Sicherheitsschaltmittel geändert. Um sicherzugehen, dass für den Funktionstest dieser geänderte Zustand des Sicherheitsschaltmittels lang genug besteht, wird der Zustand erst geändert, wenn über den Rückmeldungseingang ein erfolgreicher Funktionstest gemeldet wird oder über den Testeingang der Funktionstest beendet wird. Durch diese einfache logische Bedingung kann die Zeit für eine Testabschaltung auf ein Minimum begrenzt werden. Nach einer durch das Auswertemittel erkannten Abschaltung des Sicherheitsschaltmittels, ändert das Auswertemittel das Signal auf der Rückmeldungsverbindung. Somit wird durch die Änderung des Signals die Änderung an dem Signal an dem Betätigungsausgang des Betätigungsmittels wieder rückgängig gemacht und somit das Sicherheitsschaltmittel beispielsweise wieder eingeschaltet.

Somit schaltet das Betätigungsmittel das Sicherheitsschaltmittel wieder ein, bevor sich der Schaltzustand des Aktuators verändern kann. Vorteilhaft wird durch die kurze Testabschaltung beziehungsweise die kurze Schaltzustandsänderung des Sicherheitsschaltmittels ermöglicht, dass sich der Schaltzustand des Aktuators nicht ändert. Dies ist der Fall, da der Aktuator im Allgemeinen eine gewisse Trägheit aufweist. Diese Trägheit entsteht beispielsweise durch die bewegbaren Teile eines mechanischen Relais und durch die Selbstinduktion einer verwendeten Spule.

In noch einer weiteren bevorzugten Ausführungsform wird das Signal mit der Information über die Änderung des Signals an dem Schaltausgang an dem Funktionsmeldeausgang mindestens so lange bereitgestellt, wie ein Signal an dem Testeingang des Auswertemittels anliegt. Daher weist das Auswertemittel in einer bevorzugten Ausführungsform auch einen Testeingang auf, zum Beispiel ist dieser Testeingang mit dem Testeingang des Betätigungsmittels verbunden. Dies hat den Vorteil, dass das Auswertemittel die detektierte Schaltzustandsänderung auch noch nachdem sich der Schaltzustand des Sicherheitsschaltmittels wieder geändert hat an dem Funktionsmeldeausgang bereitstellen kann. Diese speichernde Bereitstellung hat den Vorteil, dass der Erfolg der Testabschaltung zur Funktionsüberwachung durch ein Signal an dem Funktionsmeldeausgang des Auswertemittels gemeldet wird, selbst auch dann noch, wenn der Schaltzustand des Sicherheitsmittels von dem Betätigungsmittel nach erfolgreicher Testabschaltung wieder verändert wurde. Dies ermöglicht es, die Betriebsspannung des Aktuators nur für eine sehr kurze Zeit, unabhängig von der Dauer eines Testsignals zu unterbrechen. Somit kann die Dauer des Testsignals länger als die Trägheit der Spule sein, so dass auch beispielsweise eine langsame programmierbare Logik, wie beispielsweise ein langsamer Mikrocontroller, die Schaltzustandsänderung an dem Funktionsmeldeausgang erkennen kann. Ein weitere Vorteil ist, dass dadurch auch die Anpassung der Testimpulsdauer an die Trägheit des Aktuators, beispielsweise an die Trägheit einer Spule, entfällt.

In einer weiteren bevorzugten Ausführungsform ist das Betätigungsmittel ausgestaltet das Signal am Schaltausgang des Sicherheitsschaltmittels als Reaktion auf ein Signal an dem Steuereingang zu verändern. Mit Hilfe des Signals an dem Steuereingang kann das Sicherheitsschaltmittel beispielsweise in einem sogenannten Betriebsmodus geschaltet werden. Mit Betriebsmodus ist der Modus gemeint, in dem das Sicherheitsschaltmittel gewollt und für einen längeren Zeitraum geschaltet wird und nicht für den Funktionstest. Dadurch dass dieses Signal dem Betätigungsmittel bereitgestellt wird, kann das Schalten des Sicherheitsschaltmittels immer mit Hilfe des Betätigungsmittels durchgeführt werden, d.h. unabhängig davon, ob ein Funktionstest durchgeführt wird, oder ob das Schalten im Betriebsmodus stattfinden soll. Darüber hinaus kann das Signal mit der Information über das Signal am Steuereingang auch für das Durchführen des Funktionstest hilfreich sein. Beispielsweise kann das Betätigungsmittel das Durchführen eines Funktionstests verhindern, wenn sich aus dem Signal am Steuereingang ergibt, dass das Sicherheitsschaltmittel gerade im Betriebsmodus geschaltet wird.

In noch einer weiteren bevorzugten Ausführungsform weist das Auswertemittel einen Steuereingang auf, und ist ausgestaltet im Falle des Erhalts eines Signals mit einer Information über die aktuelle Schaltzustandsänderung des Sicherheitsschaltmittels als Reaktion auf ein Signal am Steuereingang das Signal am Rückmeldungsausgang und Funktionsmeldeausgang zurückzusetzen. Beispielsweise geschieht dies durch eine Änderung der Signale, die an den jeweiligen Ausgängen anstehen. Dies ermöglicht es, einer angeschlossenen Einrichtung, wie beispielsweise einem Steuermittel, zwischen einer regulären Abschaltung über ein Signal an dem Steuereingang und einer Testabschaltung über ein Signal an dem Testeingang zu unterscheiden.

In noch einer weiteren bevorzugten Ausführungsform sind die von dem Betätigungsmittel und dem Auswertemittel in den jeweiligen Ausführungsformen ausgeführten Funktionsweisen mit fest verdrahteter Logik realisiert. Dies ermöglicht ein unmittelbares Wiedereinschalten im Falle eines erfolgreichen Funktionstests des Sicherheitsschaltmittels ohne die Notwendigkeit teure Hardwarekomponenten zu verwenden. Insbesondere wird durch eine Trennung der Elemente, die das Wiedereinschalten verursachen von den Elementen, die den Funktionstest starten und das Ergebnis verarbeiten, die Verwendung von günstigen programmierbaren Logiken, wie zum Beispiel günstigen Mikrocontrollern möglich, ohne dass dadurch der Betrieb des Aktuator beeinflusst würde.

In einer weiteren bevorzugten Ausführungsform ist das Betätigungsmittel mit logischen Gattern realisiert und das Auswertemittel mit bistabilen Kippgliedern. Das Auswertemittel beinhaltet hierfür mindestens ein bistabiles Kippglied, wie beispielsweise ein Flip-Flop. Mit Hilfe des bistabilen Kippglieds kann zum Beispiel ein Signal mit der Information über die Änderung des Signals an dem Schaltausgang für einen längeren Zeitraum bereitgestellt werden, selbst wenn sich der zugehörige Schaltzustand des Sicherheitsschaltmittels zwischenzeitlich wieder geändert hat.

Die logischen Gatter in dem Betätigungsmittel, wie beispielsweise ein UND-Gatter und ein ODER-Gatter haben den Vorteil, dass die Verzögerung einer Logik, die lediglich aus solchen logischen Gattern aufgebaut ist, sehr gering ist und somit ein sehr schnelles Wiedereinschalten nach einer Testabschaltung ermöglicht wird. Tatsächlich werden Verzögerungen lediglich durch die unterschiedlichen Signallaufzeiten und durch die unterschiedlichen Reaktionszeiten der einzelnen logischen Gatter verursacht. Diese Verzögerungen bewegen sich lediglich im Bereich von Nanosekunden und können in der Praxis für einen Großteil der Anwendungen vernachlässigt werden.

In noch einer weiteren bevorzugten Ausführungsform weist die Vorrichtung zur Funktionsüberwachung auch ein Steuermittel auf, das mit dem Testeingang des Betätigungsmittels und mit dem Funktionsmeldeausgang des Auswertemittels verbunden ist. Dies ermöglicht ein Steuern des Funktionstests und ein Auswerten der dadurch erhaltenen Ergebnisse durch das Steuermittel. In einer bevorzugten Ausführungsform ist das Steuermittel auch mit dem Steuereingang des Betätigungsmittels verbunden. Dadurch kann das komplette Schalten des Sicherheitsschaltmittels unabhängig davon, ob dieses Schalten im Betriebsmodus oder während einem Funktionstest stattfindet, von dem Steuermittel vorgenommen werden.

In einer bevorzugten Ausführungsform ist das Steuermittel ausgestaltet in periodischen Intervallen einen Funktionstest zu initiieren. Mit Hilfe derartiger periodischer Tests kann sichergestellt werden, dass ein etwaiger Fehler schnell erkannt wird. In einer bevorzugten Ausführungsform initiiert das Steuermittel den Funktionstest durch eine Änderung der Signale an dem Testeingang und dem Steuereingang des Betätigungsmittels. Dadurch können die Bedingungen für das Durchführen des Funktionstests leicht geändert werden. Vorzugsweise liegt das periodische Intervall mit dem der Funktionstest initiiert wird in einem Bereich von 5 Millisekunden bis 15 Minuten. Grundsätzlich kann das periodische Intervall aber jede Länge haben, die beispielsweise von den relevanten Normen für die unterschiedlichen Anwendungen vorgeschrieben werden, bzw. ein Intervall das dem Entwickler als angemessen erscheint. Die Länge des Testimpulses kann beispielsweise 50 bis 100 µs betragen, aber abhängig von der Anwendung auch kürzer oder länger sein. Alternativ hierzu kann der Testimpuls auch länger sein, da nach einer erfolgten Testabschaltung das Sicherheitsschaltmittel sofort wieder eingeschaltet wird, unabhängig von der Dauer des Testimpulses.

In einer weiteren bevorzugten Ausführungsform enthält das Steuermittel eine programmierbare Logik, wie beispielsweise einen Mikrocontroller. Mit Hilfe einer derartigen programmierbaren Logik kann das periodische Intervall und die Länge des Testimpulses, aber auch unterschiedliche Intervallzeiten oder Impulslängen leicht implementiert werden und die Ansteuerung weiterer Komponenten, wie zum Beispiel weiterer Sicherheitsschaltmittel in dem Schaltkreis vorgenommen werden.

Das erfindungsgemäße Verfahren zur Funktionsüberwachung eines Sicherheitsschaltmittels, welches insbesondere zum Schalten eines Aktuators verwendet werden kann, weist die folgenden Schritte auf: Ändern eines Signals an einem Betätigungsausgang eines Betätigungsmittels, der verbunden ist mit einem Betätigungseingang des Sicherheitsschaltmittels, in Abhängigkeit von einem Signal an einem Testeingang und einem Steuereingang des Betätigungsmittels, Erkennen an einem Auswertemittel eine Änderung eines Signals an einem Schaltausgang des Sicherheitsschaltmittels, Bereitstellen an einem Funktionsmeldeausgang des Auswertemittels ein Signal mit einer Information über die Änderung des Signals an dem Schaltausgang des Sicherheitsschaltmittels und Weiterleiten des Signals mit der Information über die Änderung an einen Rückmeldungseingang des Betätigungsmittels, und Rückgängigmachen der Signaländerung an dem Betätigungsausgang des Betätigungsmittels bei einem Funktionstest abhängig von dem Erhalt des Signals mit der Information über die Änderung.

### 4. Kurze Beschreibung der Zeichnungen

Im Folgenden werden die erfindungsgemäße Vorrichtung und das erfindungsgemäße Verfahren zur Funktionsüberwachung anhand der in den nachfolgenden Figuren gezeigten Ausführungsform näher erläutert. Es zeigen:
- Fig. 1:: ein Blockschaltbild einer beispielhaften Ausführungsform der erfindungsgemäßen Vorrichtung zur Funktionsüberwachung in einfacher Ausführung,
- Fig. 2:: ein Blockschaltbild einer beispielhaften Ausführungsform der erfindungsgemäßen Vorrichtung zur Funktionsüberwachung in redundanter Ausführung,
- Fig. 3:: ein vereinfachtes Schaltbild der erfindungsgemäßen Vorrichtung zur Funktionsüberwachung in dem das Betätigungsmittel und das Auswertemittel in Hardware-Logik implementiert sind,
- Fig. 4a, 4b, 4c: Zustandsdiagramme für die Ansteuerung der erfindungsgemäßen Vorrichtung zur Funktionsüberwachung, bei einfachem Ein-und Ausschalten des Sicherheitsschaltmittels und mit einem fehlerfreien und einem fehlerhaften Sicherheitsschaltmittel, und
- Fig. 5:: ein Impulsdiagramm der erfindungsgemäßen Vorrichtung zur Funktionsüberwachung bei der Durchführung eines Funktionstests.

### 5. Beschreibung der bevorzugten Ausführungsformen

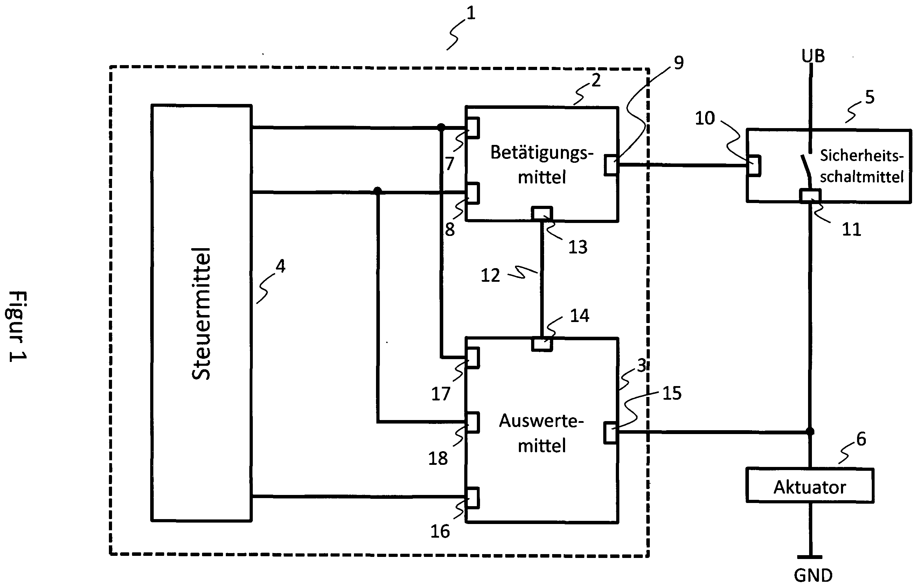

Figur 1 zeigt ein Blockschaltbild einer beispielhaften Ausführungsform der erfindungsgemäßen Vorrichtung zur Funktionsüberwachung 1 in einfacher Ausführung. Figur 1 zeigt auch ein Sicherheitsschaltmittel 5 mit dem ein Aktuator 6 geschaltet wird. Hierfür weist das Sicherheitsschaltmittel 5 einen Betätigungseingang 10 und einen Schaltausgang 11, der mit dem Aktuator 6 in Verbindung steht, auf. Mit Hilfe der erfindungsgemäßen Vorrichtung 1 soll die Funktion des Sicherheitsschaltmittels 5 überwacht werden.

Die in Figur 1 gezeigte Ausführungsform der Vorrichtung zur Funktionsüberwachung 1 besteht aus einem Betätigungsmittel 2 und einem Auswertemittel 3. Das Betätigungsmittel 2 ist über einen Betätigungsausgang 9 mit dem Betätigungseingang 10 des Sicherheitsschaltmittels 5 verbunden. Das Betätigungsmittel 2 dient zur Abgabe eines Signals über den Betätigungsausgang 9 an das Sicherheitsschaltmittel 5. Mit Hilfe dieses Signals wird das Sicherheitsschaltmittel 5 geschaltet, wenn das Sicherheitsschaltmittel 5 ordnungsgemäß funktioniert. Daher wird dieses Signal auch als Schaltsignal bezeichnet.

Im Betriebsmodus kann das Betätigungsmittel 2 das Schaltsignal beispielsweise als Reaktion auf ein Signal an einem Steuereingang 7 des Betätigungsmittels 2 abgeben. In der in Figur 1 gezeigten Ausführungsform weist die Vorrichtung zur Funktionsüberwachung 1 ein Steuermittel 4 auf, das über den Steuereingang 7 des Betätigungsmittels 2 mit dem Betätigungsmittel 2 verbunden ist. Im Betriebsmodus kann das Steuermittel 4 beispielsweise ein Signal an den Steuereingang 7 abgeben, welches das Betätigungsmittel 2 veranlasst das Signal an dem Betätigungsausgang 9 derart zu ändern, dass das Sicherheitsschaltmittel 5 geschaltet wird, zum Beispiel als Reaktion auf einen erkannten Aktuator-Fehler, wie beispielsweise verschweißte Relaiskontakte, um das Sicherheitsschaltmittel 5 zu öffnen und somit den Aktuator 6 von der Stromversorgung zu trennen.

Weiterhin weist das Betätigungsmittel 2 einen Testeingang 8 auf. Über den Testeingang 8 kann das Betätigungsmittel 2 das Signal mit der Information erhalten, dass ein Funktionstest durchgeführt werden soll. In der gezeigten Ausführungsform, geschieht dies durch ein Signal an dem Testeingang und eine gleichzeitige Wegnahme des Signals an dem Steuereingang. In der in Figur 1 gezeigten Ausführungsform ist der Testeingang 8 des Betätigungsmittels 2 mit dem Steuermittel 4 verbunden. Über diese Verbindung kann das Steuermittel 4 das Durchführen von Funktionstests des Sicherheitsschaltmittels 5 steuern. Über den Testeingang 8 können Funktionstests des Sicherheitsschaltmittels 5 zyklisch oder auch in unregelmäßigen Abständen initiiert werden. Während eines Funktionstests kann das Betätigungsmittel 2 in Abhängigkeit von dem erhaltenen Testsignal das Sicherheitsschaltmittel 5 ausschalten und wieder einschalten.

Das Auswertemittel 3 sorgt im Rahmen des Funktionstests dafür, dass der Funktionstest schnellstmöglich beendet und der Betriebsmodus weiter geführt wird. Hierfür weist das Auswertemittel 3 einen Überwachungseingang 15 auf, der mit dem Schaltausgang 11 des Sicherheitsschaltmittels 5 verbunden ist. Mit Hilfe dieses Überwachungseingangs 15 werden dem Auswertemittel 3 das Signal mit der Information über eine Änderung eines Signals an dem Schaltausgang 11 des Sicherheitsschaltmittels 5 zur Verfügung gestellt. In Abhängigkeit von dem Signal an dem Überwachungseingang 15, ändert das Auswertemittel 3 die Signale an dem Rückmeldungsausgang 14 und an dem Funktionsmeldeausgang 16.

Das Signal mit der Information über die Änderung des Signals am Schaltausgang und somit über den jeweilige Schaltzustand des Sicherheitsschaltmittels 5 wird von dem Auswertemittel 3 dem Betätigungsmittel 2 über eine Rückmeldungsverbindung 12 zur Verfügung gestellt. Aufgrund dieses Signals mit dieser Information kann das Betätigungsmittel 2 die Signaländerung an dem Betätigungsausgang 9 umgehend rückgängig machen und somit das Sicherheitsmittel 5 wieder einschalten, bevor der Funktionstest durch das Ende des Testsignals beendet ist.

In der vorliegenden Ausführungsform wird das Signal mit der Information über den Schaltzustand des Sicherheitsschaltmittels 5 über einen Funktionsmeldeausgang 16 des Auswertemittels 3 dem Steuermittel 4 zur Verfügung gestellt. In der vorliegenden Ausführungsform wird dieses Signal mit dieser Information zur Verfügung gestellt, unabhängig davon, ob das Sicherheitsschaltmittel 5 wieder eingeschaltet wurde oder nicht.

In der vorliegenden Ausführungsform weist das Auswertemittel 3 auch einen Steuereingang 17 und einen Testeingang 18 auf. Somit kann das Auswertemittel 3 zwischen einer Abschaltung des Sicherheitsschaltmittels 5 aufgrund eines Funktionstests oder einer gewollten Abschaltung unterscheiden. Das Bereitstellen des Steuereingangs 17 und des Testeingangs 18 ist aber nur eine mögliche Realisierung. Es gibt auch Lösungen, bei denen nur einer der beiden Eingänge notwendig ist. Darüber hinaus kann diese Funktion beispielsweise auch dadurch erzielt werden, dass das Betätigungsmittel 2 derart geschaltet ist, dass nur wenn an dem Testeingang 8 der Funktionstest angezeigt wird, das Rückmeldungssignal Auswirkung auf den Betätigungsausgang 9 haben kann.

Das Sicherheitsschaltmittel 5 kann ein elektronischer Halbleiterschalter sein. Alternativ kann das Sicherheitsschaltmittel 5 aber auch aus einem mechanischen Relais gebildet werden.

In der gezeigten Ausführungsform ist die Betriebsspannung des Aktuators 6 und die Betriebsspannung der Vorrichtung zur Funktionsüberwachung 1 gleich. Alternativ könnten der Aktuator 6 und die Vorrichtung zur Funktionsüberwachung 1 unterschiedliche Betriebsspannungen haben. Beispielsweise kann die geschaltete Betriebsspannung für den Aktuator 6 höher sein, als die Spannung der Vorrichtung zur Funktionsüberwachung 1. In diesem Fall kann zusätzlich vor dem Überwachungseingang 15 des Auswertemittels 3 ein Mittel zur Herabsetzung der Spannung (nicht in den Figuren gezeigt) angeordnet sein. Dieses Mittel könnte beispielsweise durch eine Spannungsteiler-Schaltung oder einen Transformator, jeweils mit oder ohne Spannungsgleichrichter, gebildet werden.

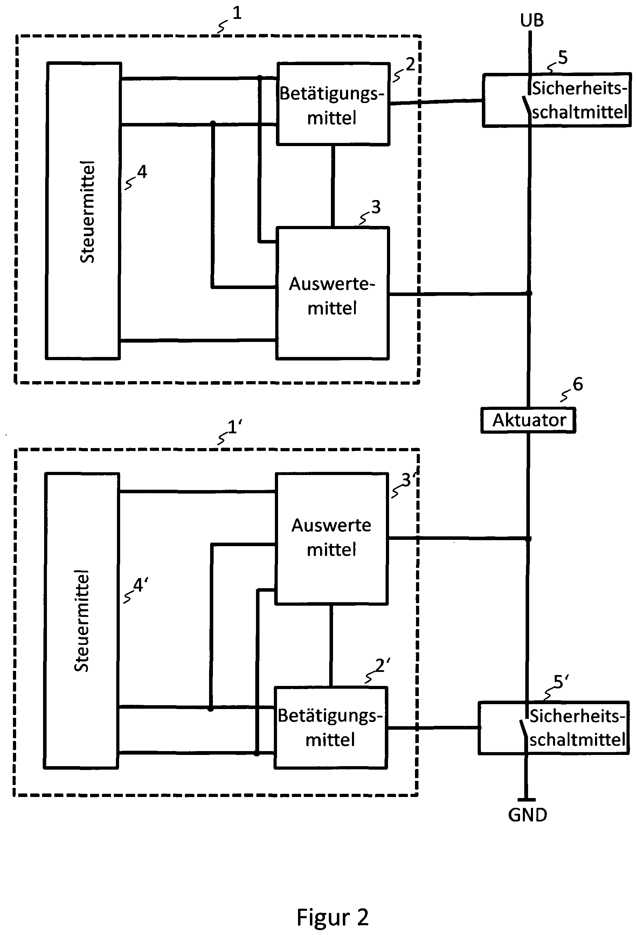

Die Figur 2 zeigt eine Ausführungsform der erfindungsgemäßen Vorrichtung zur Funktionsüberwachung 1 in redundanter Ausführung. Für das Erreichen einer höchsten Sicherheitsstufe, wird das Sicherheitsschaltmittel 5, sowie die daran angeschlossene Vorrichtung zur Funktionsüberwachung 1 doppelt ausgeführt. Zusätzlich kann auch das Steuermittel 4 redundant ausgeführt werden.

In der in Figur 2 gezeigten Ausführungsform befinden sich zwei Sicherheitsschaltmittel 5,5' in dem Strompfad eines Aktuators 6. Das erste Sicherheitsschaltmittel 5 schaltet den Aktuator 6 gegen die positive Versorgungsspannung, UB, wobei das zweite Sicherheitsschaltmittel 5' den Aktuator 6 gegen die Masse, GND, schaltet.

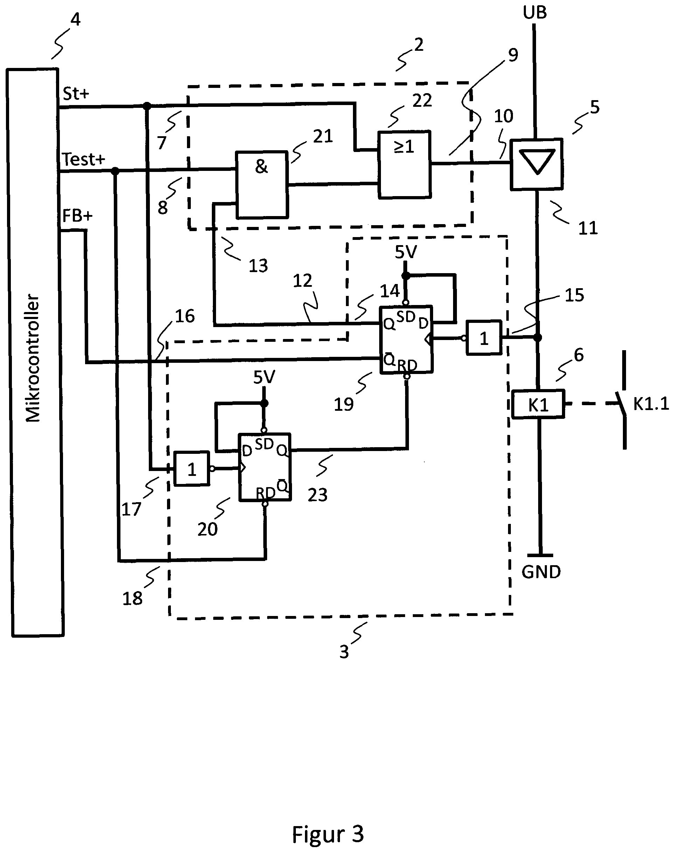

Figur 3 zeigt eine Realisierung der in den Figuren 1 und 2 gezeigten Betätigungsmittel 2 und Auswertemittel 3 mittels einer aus Hardwarekomponenten bestehenden Logik.

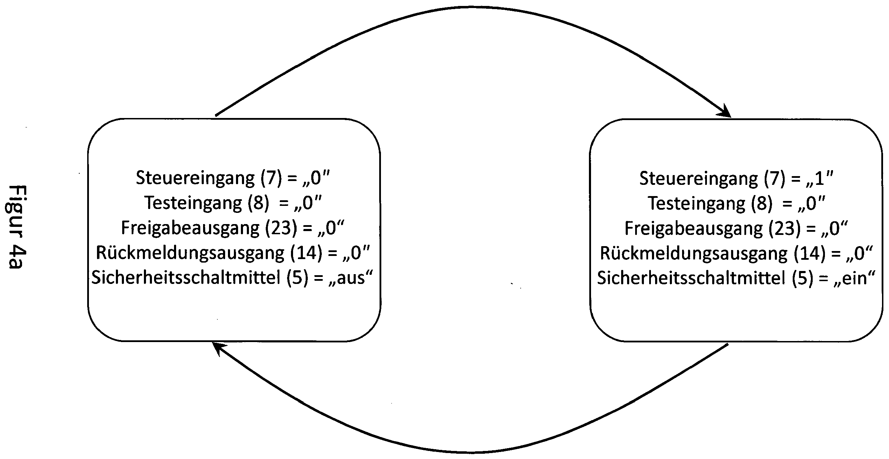

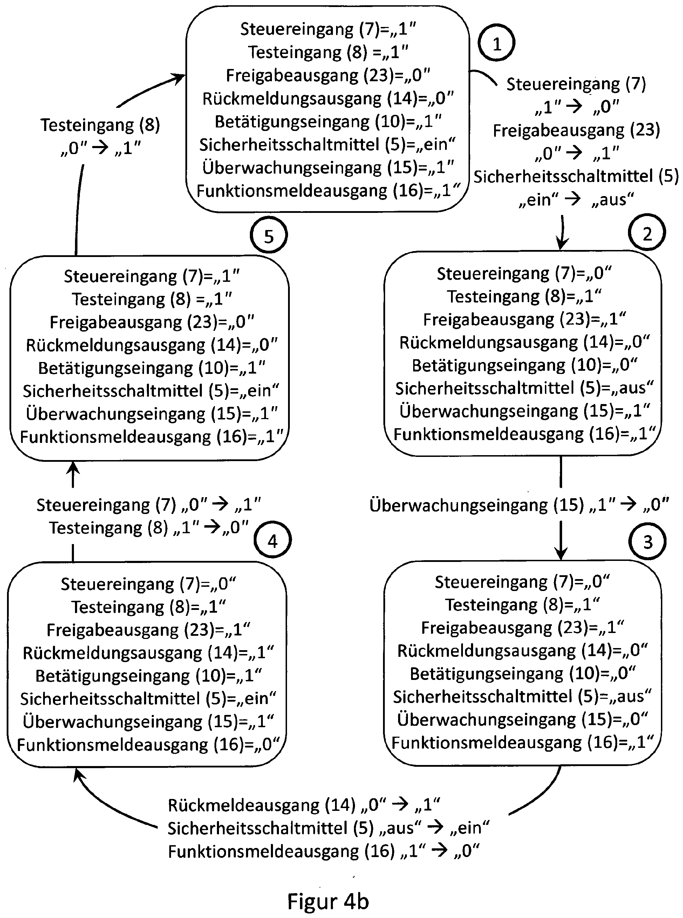

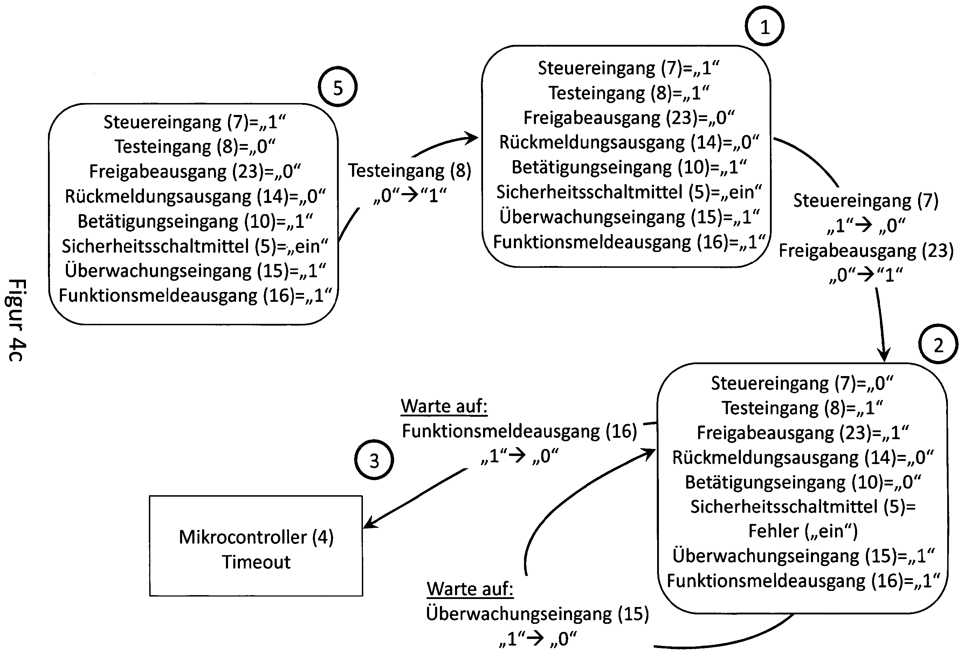

In der in Figur 3 gezeigten Ausführungsform wird das Betätigungsmittel 2 aus einem UND-Glied 21 und aus einem ODER-Glied 22 mit jeweils 2 Eingängen gebildet. Der Steuereingang 7 des Betätigungsmittels 2 ist an dem ODER-Glied 22 angeschlossen, so dass ein "1" Signal am Steuereingang 7 das Sicherheitsschaltmittel 5 betätigt. An dem zweiten Eingang des ODER-Glieds 22 ist der Ausgang des UND-Glieds 21 angeschlossen. Wie es in der Figur 3 gezeigt ist, verknüpft das UND-Glied 21 das Signal an dem Testeingang 8 und dem Rückmeldungseingang 13 des Betätigungsmittels 2. Wie es in der nachfolgenden Beschreibung des Impulsdiagramms von Figur 4 anhand des gezeigten Beispiels noch deutlicher werden wird, bewirkt diese UND-Verknüpfung, dass nach einer Abschaltung im Zusammenhang mit einem Funktionstest des Sicherheitsschaltmittels 5, das Sicherheitsschaltmittel 5 sofort wieder eingeschaltet wird. Dies geschieht hier durch das gleichzeitige Anliegen eines Signals an dem Testeingang 8 und an dem Rückmeldungseingang 13 des Betätigungsmittels 2.

Das Signal an dem Rückmeldungseingang 13 des Betätigungsmittels 2 wird von dem Auswertemittel 3 bereitgestellt. Die Funktion des Auswertemittels 3 ist eine Abschaltung im Rahmen eines Funktionstests zu erkennen und diese Abschaltung dem Steuermittel 4 über ein Signal an dem Funktionsmeldeausgang 16 und dem Betätigungsmittel 2 über ein Signal an dem Rückmeldungseingang 13 anzuzeigen.

In der gezeigten Ausführungsform ist das Auswertemittel 3 mit 2 flankengesteuerten D-Flip-Flops 19, 20 realisiert. Wie es in der Figur 4b gezeigt ist, sind die Flip-Flops 19, 20 so verschaltet, dass eine Signaländerung an dem Steuereingang 7 und an dem Testeingang 8, die Flip-Flops 19, 20 initialisiert, d.h. die Signale an dem Freigabeausgang 23 des Flip-Flops 19 und an dem Rückmeldungsausgang 14 des Flip-Flops 20 werden auf "0" gesetzt, so dass sie auf "Flanken", die durch den darauffolgenden Testablauf hervorgerufen werden reagieren. Eine durch eine Funktionsprüfung erfolgte Abschaltung wird somit als eine Signaländerung von "1" auf "0", bzw. von "0" auf "1" durch Negierung des am Überwachungseingang 15 angeschlossenen Flip-Flops 19 registriert. Das flankengesteuerte Flip-Flop 19 ändert daraufhin den Schaltzustand an seinen Ausgängen, so dass das Signal an dem Rückmeldungsausgang 14 von "0" auf "1" gesetzt wird, um dem Betätigungsmittel 2 das erfolgreiche Abschalten zu signalisieren. Gleichzeitig ändert sich auch das Signal an dem Funktionsmeldeausgang 16 mit dem das Steuermittel 4 verbunden ist, das hier als Mikrocontroller gezeigt ist. Das Signal an dem Funktionsmeldeausgang 16 wird speichernd dem Mikrocontroller bereitgestellt. Das bedeutet, dass das Signal auch noch nach dem Wiedereinschalten des Sicherheitsschaltmittels 5 und nach der Signaländerung an dem Steuereingang 17 angezeigt wird. Durch die darauffolgende Änderung des Signals an dem Testeingang 18 werden die Flip-Flops 19, 20 wieder in den Zustand vor der Funktionsprüfung gebracht.

Figur 4a zeigt ein Zustandsdiagramm für die Ansteuerung der erfindungsgemäßen Vorrichtung zur Funktionsüberwachung in der Ausführungsform, wie sie in der Figur 3 gezeigt wird, bei fehlerfreiem Betrieb. Zur Verdeutlichung der grundsätzlichen Funktionsweise der Vorrichtung zur Funktionsüberwachung wird hier gezeigt, dass ein Signal an dem Steuereingang 7 des Betätigungsmittels 2 das Sicherheitsschaltmittel 5 einschaltet und zugleich, dass der Wegfall dieses Signals an dem Steuereingang 7 des Betätigungsmittels 2 das Sicherheitsschaltmittel 5 ausschaltet. Die Signale an dem Freigabeausgang 23 und an dem Rückmeldungsausgang 14, der in Figur 3 gezeigten Flip-Flops 19, 20, ändern sich nicht.

In Figur 4b wird ein Zustandsdiagramm für die Ansteuerung der erfindungsgemäßen Vorrichtung zur Funktionsüberwachung, in der Ausführungsform wie sie in der Figur 3 gezeigt wird, bei der Durchführung eines Funktionstests mit Wiedereinschalten und mit einem fehlerfreien Sicherheitsschaltmittel gezeigt.

Zunächst wird für die Durchführung des Funktionstests, wie es in dem Knoten 1 gezeigt ist, der Testeingang 8 des Betätigungsmittels 2 auf "1" gesetzt, während sich der Steuereingang 7 noch auf "1" befindet, um somit das Sicherheitsschaltmittel 5 in einem eingeschalteten Zustand zu halten. Dieser Signalwechsel an dem Testeingang 8 bewirkt aber noch nicht, dass das Sicherheitsschaltmittel 5 ausgeschaltet wird.

Wie es im Knoten 2 gezeigt ist, wird durch ein Wegnehmen des Signals an dem Steuereingang 7, d.h. durch eine Änderung von "1" auf "0", der eigentliche Funktionstest durchgeführt. Diese Signaländerung bewirkt, dass das Sicherheitsschaltmittel 5 ausgeschaltet wird. Daher befindet sich auch der Betätigungseingang 10 des Sicherheitsschaltmittels 5 auf "0", wie es in dem Knoten 3 gezeigt ist.

Durch die Signaländerung am Überwachungseingang 15 des Auswertemittels 3, hervorgerufen durch das Abschalten des Sicherheitsschaltmittels 5, wird das Flip-Flop 19 gesetzt, was wiederum eine Signaländerung von "0" auf "1" am Rückmeldungseingang 13 des Betätigungsmittels 2 bewirkt. Wie es in Knoten 4 gezeigt ist, bewirkt das "1" Signal am Rückmeldungseingang 13 des Betätigungsmittels 2, bzw. das "1" Signal am Rückmeldungsausgang 14 des Auswertemittels 3 und das immer noch anstehende Testsignal 8, dass das Sicherheitsschaltmittel 5 durch ein "1" Signal an dessen Betätigungseingang 10 wieder eingeschaltet wird.

Im Knoten 5 wird nun gezeigt, dass eine Änderung des Steuereingangs auf "1" und eine Änderung des Testeingangs auf "0" das Sicherheitsschaltmittel 5 weiter in einem eingeschalteten Zustand halten, wobei beide Flip-Flops 19, 20 für die Durchführung eines weiteren Funktionstests zurückgesetzt werden, das bedeutet, dass die Signale am Freigabeausgang 23 und am Rückmeldungsausgang 14 auf "0" gesetzt werden.

In Figur 4c wird ein Zustandsdiagramm für die Ansteuerung der erfindungsgemäßen Vorrichtung zur Funktionsüberwachung in der Ausführungsform, wie sie in der Figur 3 gezeigt wird, bei der Durchführung eines Funktionstests gezeigt, in dem das Sicherheitsschaltmittel 5 wegen des Vorliegens eines Fehlers nicht wiedereingeschaltet wird.

Zunächst wird, wie es bezüglich Knoten 1 und 2 in Figur 4b beschrieben ist, eine Testabschaltung durchgeführt. Allerdings wird nun, durch das Anliegen eines "1" Signals an dem Überwachungseingang 15 des Auswertemittels 3 auch nach dem Wegfall des Signals an dem Betätigungseingang 10 angezeigt, dass das Sicherheitsschaltmittel 5 nicht einwandfrei funktioniert, da es sich immer noch in einem geschlossenen Zustand befindet. Dies kann beispielsweise durch das "Verkleben" von Relaiskontakte des Sicherheitsschaltmittels 5 hervorgerufen worden sein. Wegen dem Fehlen einer Signaländerung am Überwachungseingang 15 des Auswertemittels 3 wird daher auch nicht das Flip-Flop 19 gesetzt, somit findet auch keine Signaländerung an dem Funktionsmeldeausgang 16 des Auswertemittels 3 statt. Der Mikrocontroller 4 kann nun eine sicherheitsgerichtete Abschaltung des Aktuators 6 einleiten.

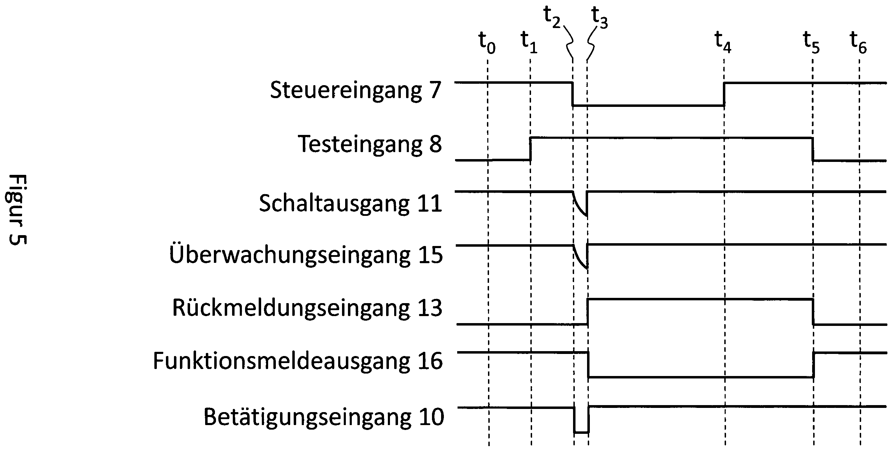

Fig. 5 zeigt ein Impulsdiagramm für die Ansteuerung der erfindungsgemäßen Vorrichtung zur Funktionsüberwachung 1 in den Ausführungsformen, wie sie in den Figuren 1 bis 3 gezeigt werden, bei fehlerfreiem Betrieb. Neben dem Steuereingang 7, dem Testeingang 8 und dem Funktionsmeldeausgang 16 werden in Figur 5 zum Zwecke der Anschaulichkeit auch der Betätigungseingang 10 und der Schaltausgang 11 des Sicherheitsschaltmittels 5, der Überwachungseingang 15 des Auswertemittels 3 und das Signal an dem Rückmeldungseingang 13 des Betätigungsmittels 2 gezeigt.

In Figur 5 wird die Durchführung eines Funktionstests beschrieben. Im Zeitpunkt t₁ ist das Eingangssignal am Steuereingang 7 auf "1" gesetzt und das Eingangssignal am Testeingang 8 ist auf "0" gesetzt. Das Signal an dem Rückmeldungseingang 13 befindet sich auf "0". Das Funktionsmeldesignal am Funktionsmeldeausgang 16 befindet sich auf "1" und das Sicherheitsschaltmittel 5 ist geschlossen. Der im Zeitpunkt t₀ gezeigte Zustand der Signale stellt den Normalbetrieb dar. Der angeschlossene Aktuator 6 wird mit Spannung versorgt. Über den Funktionsmeldeausgang 16 überwacht die Software im Steuermittel 4 permanent den Normalbetrieb, d.h. sie überprüft den Istwert am Sicherheitsschaltmittel 5 im Hinblick auf Abweichungen vom Sollwert am Steuereingang 7.

Im Zeitpunkt t₁ wird der Funktionstest des Sicherheitsschaltmittels 5 von der Software im Steuermittel 4 vorbereitet. Die Vorbereitung erfolgt durch das auf "1" Setzen des Testeingangs 8. Der eigentliche Funktionstest wird aber dadurch noch nicht gestartet. Das Sicherheitsschaltmittel 5 wird entsprechend des Sollwertes am Betätigungsausgang 9 des Betätigungsmittels 2 weiterhin angesteuert und der angeschlossene Aktuator 6 mit Spannung versorgt.

In der gezeigten Ausführungsform bewirkt die Vorbereitung, dass das Betätigungsmittel 2 und das Auswertemittel 3 wegen der Realisierung mit Flip-Flops 19, 20, wie es in Figur 3 gezeigt ist, auf "Flanken", die durch den nachfolgend beschriebenen Testablauf hervorgerufen werden, reagieren.

Im Zeitpunkt t₂ wird der eigentliche Funktionstest des Sicherheitsschaltmittels 5 gestartet. Die Software im Steuermittel 4 schaltet den Sollwert am Steuereingang 7 des Betätigungsmittels 2 von "1" auf "0" und das Betätigungsmittel 2 reagiert mit einem Abschalten des Sicherheitsschaltmittels 5, indem der Betätigungseingang 10 des Sicherheitsschaltmittels 5 auf "0" gesetzt wird. Das Auswertemittel 3 überwacht den Ausgangspegel am Aktuator 6, bzw. an dem Sicherheitsschaltmittel 5 durch den Überwachungseingang 15.

Mit einer Verzögerung, die durch den Spannungsverlauf am Aktuator 6 bestimmt wird, unterschreitet die Spannung am Überwachungseingang 15 im Zeitpunkt t₃ den Schwellwert, ab dem das Auswertemittel 3 ein Abschalten des Aktuators 6 erkennt. Die Verzögerung ist in Figur 5 bezüglich der Schaltzustände des Schaltausgangs 11 und des Überwachungseingangs 15 grafisch angedeutet. Das Auswertemittel 3 bemerkt zu diesem Zeitpunkt, dass das Sicherheitsschaltmittel 5 abgeschaltet wurde und reagiert unmittelbar mit einem "1" Signal am Rückmeldungseingang 13. Das Signal am Rückmeldungseingang 13 wird dem Betätigungsmittel 2 zugeführt, um dadurch das Wiedereinschalten des Sicherheitsschaltmittels 5 durch das Betätigungsmittel 2 einzuleiten, indem das Signal an dem Betätigungseingang 10 des Sicherheitsschaltmittels 5 wieder auf 1 gesetzt wird. Zu diesem Zeitpunkt ist der Steuereingang 7 weiterhin auf "0".

Durch das Wiedereinschalten wird der Aktuator 6 wieder mit Spannung versorgt. Da das Auswertemittel 3 automatisch auf den erfolgreichen Funktionstest reagiert und das Sicherheitsschaltmittel 5 wieder einschaltet, wird der Funktionstest für den angeschlossenen Aktuator 6 so kurz wie möglich gehalten.

Im Zeitpunkt t₄ hat das Steuermittel 4 das Signal am Funktionsmeldeausgang 16 des Auswertemittels 3 eingelesen und den erfolgreich durchgeführten Funktionstest erkannt und das Signal am Steuereingang 7 des Betätigungsmittels 2 wird von dem Steuermittel 4 wieder von "0" auf "1" gesetzt.

Der Funktionstest für das Sicherheitsschaltmittel 5 ist erfolgreich durchlaufen worden. Das Signal am Testeingang 8 wird vom Steuermittel 4 wieder von "1" nach "0" zurückgesetzt. Dadurch wird das zuvor vom Auswertemittel 3 ausgegebene Signal am Rückmeldungseingang 13 auch wieder von "1" nach "0" gesetzt und somit gelöscht.

Im Zeitpunkt t₆ haben die Eingänge und Ausgänge wieder die gleichen Zustände wie vor der Durchführung des Funktionstests. Das Steuermittel 4 steuert nun wieder den Steuereingang 7 des Betätigungsmittels 2. Die Signale in dem in Figur 5 gezeigten und oben beschriebenen Impulsdiagramm für die Ansteuerung der erfindungsgemäßen Vorrichtung zur Funktionsüberwachung 1 können abhängig von der Implementierung mit logischen Komponenten zu den verschiedenen gezeigten Zeitpunkten auch andere Zustände einnehmen. Beispielsweise könnten alle gezeigten Signalzustände invertiert sein.

### Bezugszeichenliste

- 1: Vorrichtung zur Funktionsüberwachung
- 2: Betätigungsmittel
- 3: Auswertemittel
- 4: Steuermittel
- 5: Sicherheitsschaltmittel
- 6: Aktuator
- 7: Steuereingang
- 8: Testeingang
- 9: Betätigungsausgang
- 10: Betätigungseingang
- 11: Schaltausgang
- 12: Rückmeldungsverbindung
- 13: Rückmeldungseingang
- 14: Rückmeldungsausgang
- 15: Überwachungseingang
- 16: Funktionsmeldeausgang
- 17: Steuereingang
- 18: Testeingang
- 19, 20: Flip-Flops
- 21: UND-Glied
- 22: ODER-Glied
- 23: Freigabeausgang

## Patentansprüche

1. Eine Vorrichtung (1) zur Funktionsüberwachung eines Sicherheitsschaltmittels (5), welches insbesondere zum Schalten eines Aktuators (6) verwendet werden kann, wobei das Sicherheitsschaltmittel (5) einen Betätigungseingang (10) und einen Schaltausgang (11) aufweist, die Vorrichtung (1) aufweisend:
ein Betätigungsmittel (2) mit einem Steuereingang (7), einem Testeingang (8), einem Rückmeldungseingang (13) und einem Betätigungsausgang (9) zur Verbindung mit dem Betätigungseingang (10) des Sicherheitsschaltmittels (5), wobei mit Hilfe eines Signals an dem Steuereingang (7) das Sicherheitsschaltmittel (5) in einem Betriebsmodus geschaltet wird und mit Hilfe eines Signals an dem Testeingang (8) ein Funktionstest initiiert wird; und
ein Auswertemittel (3) mit einem Überwachungseingang (15) zur Verbindung mit dem Schaltausgang (11) des Sicherheitsschaltmittels (5), einem Funktionsmeldeausgang (16) und einem Rückmeldungsausgang (14),
wobei das Betätigungsmittel (2) ausgestaltet ist für einen Funktionstest des Sicherheitsschaltmittels (5) ein Signal an dem Betätigungsausgang (9) in Abhängigkeit von einem Signal an dem Testeingang (8) und dem Steuereingang (7) zu ändern,
wobei das Auswertemittel (3) ausgestaltet ist über den Überwachungseingang (15) eine Änderung eines Signals an dem Schaltausgang (11) des Sicherheitsschaltmittels (5) zu erkennen, ein Signal mit einer Information über die Änderung über den Rückmeldungsausgang (14) des Auswertemittels (3) an den Rückmeldungseingang (13) des Betätigungsmittels (2) weiterzuleiten und ein Signal mit einer Information über die Änderung an dem Funktionsmeldeausgang (16) bereitzustellen, und
wobei das Betätigungsmittel (2) außerdem ausgestaltet ist bei einem Funktionstest im Falle des Erhalts eines Signals mit einer Information über die Änderung des Signals an dem Schaltausgang (11) des Sicherheitsschaltmittels (5) umgehend die Signaländerung an dem Betätigungsausgang (9) rückgängig zu machen.

2. Die Vorrichtung (1) zur Funktionsüberwachung nach Anspruch 1, wobei sich bei Erhalt des Signals mit der Information über die Änderung des Signals an dem Schaltausgang (11) des Sicherheitsschaltmittels (5) an dem Rückmeldungseingang (13) des Betätigungsmittels (2) ein Signal ändert und wobei das Betätigungsmittel (2) ausgestaltet ist das Signal am Betätigungsausgang (9) so lange geändert zu lassen, wie sich das Signal an dem Testeingang (8) und das Signal an dem Rückmeldungseingang (13) des Betätigungsmittels (2) nicht ändern.

3. Die Vorrichtung (1) zur Funktionsüberwachung nach einem der Ansprüche 1 oder 2, wobei sich durch das Ändern des Signals an dem Betätigungsausgang (9) das Signal an dem Schaltausgang (11) des Sicherheitsschaltmittels (5) ändert.

4. Die Vorrichtung (1) zur Funktionsüberwachung nach einem der Ansprüche 1 bis 3, wobei das Auswertemittel (3) einen Testeingang (18) aufweist.

5. Die Vorrichtung (1) zur Funktionsüberwachung nach Anspruch 4, wobei das Signal mit der Information über die Änderung des Signals an dem Schaltausgang (11) an dem Funktionsmeldeausgang (16) mindestens so lange bereitgestellt wird, wie ein Signal an dem Testeingang (18) des Auswertemittels (3) anliegt.

6. Die Vorrichtung (1) zur Funktionsüberwachung nach einem der Ansprüche 1 bis 5, wobei das Betätigungsmittel (2) ausgestaltet ist das Signal am Schaltausgang (11) des Sicherheitsschaltmittels (5) als Reaktion auf ein Signal an dem Steuereingang (7) zu verändern.

7. Die Vorrichtung (1) zur Funktionsüberwachung nach einem der Ansprüche 1 bis 6, wobei das Auswertemittel (3) einen Steuereingang (17) aufweist, und wobei das Auswertemittel (3) ausgestaltet ist nach dem Erhalt eines Signals mit einer Information über die Änderung des Signals am Schaltausgang (11) des Sicherheitsschaltmittels (5) als Reaktion auf eine Änderung des Signals an dem Steuereingang (17) die Signale am Rückmeldungsausgang (14) und am Funktionsmeldeausgang (16) zurückzusetzen.

8. Die Vorrichtung (1) zur Funktionsüberwachung nach einem der Ansprüche 1 bis 7, wobei das Betätigungsmittel (2) und das Auswertemittel (3) die in den jeweiligen Ansprüchen definierte Funktionsweise mit aus fest verdrahteter Logik realisieren.

9. Die Vorrichtung (1) zur Funktionsüberwachung nach einem der Ansprüche 1 bis 8, wobei das Betätigungsmittel (2) mit logischen Gattern realisiert ist und das Auswertemittel (3) mit bistabilen Kippgliedern (19, 20) realisiert ist.

10. Die Vorrichtung (1) zur Funktionsüberwachung nach einem der Ansprüche 1 bis 9, weiter aufweisend:
ein Steuermittel (4), das mit dem Testeingang (8) des Betätigungsmittels (2) und mit dem Funktionsmeldeausgang (16) des Auswertemittels (3) verbunden ist.

11. Die Vorrichtung (1) zur Funktionsüberwachung nach einem der Ansprüche 9 oder 10, wobei das Steuermittel (4) ausgestaltet ist in periodischen Intervallen einen Funktionstest zu initiieren.

12. Die Vorrichtung (1) zur Funktionsüberwachung nach Anspruch 11, wobei das Steuermittel (4) den Funktionstest durch eine Änderung des Signals an dem Testeingang (8) und dem Steuereingang (7) des Betätigungsmittels (2) initiiert.

13. Die Vorrichtung (1) zur Funktionsüberwachung nach einem der Ansprüche 11 oder 12, wobei das periodische Intervall zwischen 5 Millisekunden und 15 Minuten beträgt.

14. Die Vorrichtung (1) zur Funktionsüberwachung nach einem der Ansprüche 9 bis 13, wobei das Steuermittel (4) eine programmierbare Logik enthält.

15. Ein Verfahren zur Funktionsüberwachung eines Sicherheitsschaltmittels (5), welches insbesondere zum Schalten eines Aktuators (6) verwendet werden kann, das Verfahren aufweisend:
Ändern eines Signals an einem Betätigungsausgang (9) eines Betätigungsmittels (2) der verbunden ist mit einem Betätigungseingang (10) des Sicherheitsschaltmittels (5) in Abhängigkeit von einem Signal an einem Testeingang (8) und einem Steuereingang (7) des Betätigungsmittels (2), wobei mit Hilfe eines Signals an dem Steuereingang (7) das Sicherheitsschaltmittel (5) in einem Betriebsmodus geschaltet wird und mit Hilfe eines Signals an dem Testeingang (8) ein Funktionstest initiiert wird;
Erkennen an einem Auswertemittel (3) eine Änderung eines Signals an einem Schaltausgang (11) des Sicherheitsschaltmittels (5);
Bereitstellen an einem Funktionsmeldeausgang (16) des Auswertemittels (3) ein Signal mit einer Information über die Änderung des Signals an dem Schaltausgang (11) des Sicherheitsschaltmittels (5) und Weiterleiten des Signals mit der Information über die Änderung an einen Rückmeldungseingang (13) des Betätigungsmittels (2); und
Rückgängig machen der Signaländerung an dem Betätigungsausgang (9) des Betätigungsmittels (2) bei einem Funktionstest abhängig von dem Erhalt des Signals mit der Information über die Änderung.

## Claims

1. An apparatus (1) for function monitoring of a safety switching means (5), which may be used in particular for switching of an actuator (6), wherein the safety switching means (5) comprises an actuation input (10) and a switching output (11), the apparatus (1) comprising:
an actuation means (2) with a control input (7), a test input (8), a feedback input (13) and an actuation output (9) for connection with the actuation input (10) of the safety switching means (5), wherein, by ease of a signal at the control input (7), the safety switching means (5) is switched into an operation mode and, by ease of a signal at the test input (8) a function test is initiated; and
an analysis means (3) with a monitoring input (15) for connection with the switching output (11) of the safety switching means (5), a function report output (16) and a feedback output (14),
wherein the actuation means (2) is configured to change a signal at the actuation output (9) in dependency on a signal at the test input (8) and the control input (7) for a function test of the safety switching means (5), wherein the analysis means (3) is configured to recognize a signal chance at the switching output (11) of the safety switching means (5), to forward a signal with an information about the change via the feedback output (14) of the analysis means (3) to the feedback input (13) of the actuation means (2) and to provide a signal with an information about the change to the function report output (16), and
wherein the actuation means (2) is further configured, during a function test, to immediately reverse the signal change at the actuation output (9) in the case of obtaining a signal with an information about the change of the signal at the switching output (11) of the safety switching means (5).

2. The apparatus (1) for function monitoring of claim 1, wherein, when the signal with the information about the change of the signal at the switching output (11) of the safety switching means (5) is received, a signal at the feedback input (13) of the actuation means (2) changes and wherein the actuation means (2) is configured to keep the signal at the actuation output (9) changed for as long as the signal at the test input (8) and the signal at the feedback input (13) of the actuation means (2) are not changing.

3. The apparatus (1) for function monitoring according to any of the claims 1 or 2, wherein the signal at the switching output (11) of the safety switching means (5) is changed by the change of the signal at the actuation output (9).

4. The apparatus (1) for function monitoring according to any of the claims 1 to 3, wherein the analysis means (3) comprises a test input (18)

5. The apparatus (1) for function monitoring according to claim 4, wherein the signal with the information about the change of the signal at the switching output (11) is provided at the function report output (16) at least as long as a signal at the test input (18) of the analysis means (3) is present.

6. The apparatus (1) for function monitoring according to any of the claims 1 to 5, wherein the actuation means (2) is configured to change the signal at the switching output (11) of the safety switching means (5) in reaction to a signal at the control input (7).

7. The apparatus (1) for function monitoring according to any of the claims 1 to 6, wherein the analysis means (3) comprises a control input (17), and wherein the analysis means (3) is configured to reset the signals at the feedback output (14) and at the function report output (16) after the reception of a signal with information about the change of the signal at the switching output (11) of the safety switching means (5) in reaction to a change of the signal at the control input (17).

8. The apparatus (1) for function monitoring according to any of the claims 1 to 7, wherein the actuation means (2) and the analysis means (3) realize the functionality defined in the respective claims with a fixed wired logic.

9. The apparatus (1) for function monitoring according to any of the claims 1 to 8, wherein the actuation means (2) is realized with logic gates and the analysis means (3) is realized with bistable flip-flops (19,20).

10. The apparatus (1) for function monitoring according to any of the claims 1 to 9, further comprising:
a control means (4), which is connected to the test input (8) of the actuation means (2) and to the function report output (16) of the analysis means (3).

11. The apparatus (1) for function monitoring according to any of the claims 9 or 10, wherein the control means (4) is configured to initiate a function test in periodic intervals.

12. The apparatus (1) for function monitoring according to claim 11, wherein the control means (4) initiates the function test by a change of the signal at the test input (8) and the control input (7) of the actuation means (2).

13. The apparatus (1) for function monitoring according to any of the claims 11 or 12, wherein the periodic interval is between 5 milliseconds and 15 minutes.

14. The apparatus (1) for function monitoring according to any of the claims 9 to 13, wherein the control means (4) includes a programmable logic.

15. A method for function monitoring of a safety switching means (5), which may be used in particular for switching of an actuator (6), the method comprising:
changing of a signal at an actuation input (9) of a actuation means (2), which is connected to an actuation input (10) of the safety switching means (5) in dependency on a signal at a test input (8) and a control input (7) of the actuation means (2), wherein the safety switching means (5) is switched in an operating mode by ease of a signal at the control input (7) and a function test is initiated by ease of a signal at the test input (8);
recognizing, at an analysis means (3), a change of a signal at a switching output (11) of the safety switching means (5);
providing, at a function report output (16) of the analysis means (3) a signal with information about the change of the signal at the switching output (11) of the safety switching means (5) and forwarding the signal with the information about the change at a feedback report input (13) of the actuation means (2); and
reversing the signal change at the actuation output (9) of the actuation means (2) in case of a function test depending on the reception of the signal with the information about the change.

## Revendications

1. Un dispositif (1) de surveillance fonctionnelle d'un moyen de commutation de sécurité (5) qui peut être utilisé en particulier pour commuter un actionneur (6), le moyen de commutation de sécurité (5) comportant une entrée d'actionnement (10) et une sortie de commutation (11), le dispositif (1) comprenant :
un moyen d'actionnement (2) avec une entrée de commande (7), une entrée de test (8), une entrée de retour (13) et une sortie d'actionnement (9) pour le relier à l'entrée d'actionnement (10) du moyen de commutation de sécurité (5), le moyen de commutation de sécurité (5) étant commuté dans un mode de fonctionnement à l'aide d'un signal à l'entrée de commande (7), et un test fonctionnel étant déclenché à l'aide d'un signal à l'entrée de test (8) ; et
un moyen d'analyse (3) avec une entrée de surveillance (15) pour le relier à la sortie de commutation (11) du moyen de commutation de sécurité (5), une sortie de message fonctionnel (16) et une sortie de retour (14), le moyen d'actionnement (2) étant conçu, pour un test fonctionnel du moyen de commutation de-sécurité (5), pour modifier un signal à la sortie d'actionnement (9) en fonction d'un signal à l'entrée de test (8) et de l'entrée de commande (7), le moyen d'analyse (3) étant conçu pour détecter une modification du signal à la sortie de commutation (11) du moyen de commutation de sécurité (5) par l'intermédiaire de l'entrée de surveillance (11), pour transmettre à l'entrée de retour (13) du moyen d'actionnement (2) un signal avec une information sur la modification par l'intermédiaire de la sortie de retour (14) du moyen d'analyse (3) et pour fournir un signal avec une information sur la modification à la sortie de message fonctionnel (16) et, en outre, le moyen d'actionnement (2) étant conçu, lors d'un test fonctionnel en cas d'obtention d'un signal avec une information sur la modification du signal à la sortie de commutation (11) du moyen de commutation de sécurité (5), pour annuler aussitôt la modification de signal à la sortie d'actionnement (9).

2. Le dispositif (1) de surveillance fonctionnelle selon la revendication 1, en cas d'obtention du signal avec l'information sur la modification du signal à la sortie de commutation (11) du moyen de commutation de sécurité (5), un signal se modifiant à l'entrée de retour (13) du moyen d'actionnement (2), et le moyen d'actionnement (2) étant conçu pour laisser le signal à la sortie d'actionnement (9) modifié tant que le signal à l'entrée de test (8) et le signal à l'entrée de retour (13) du moyen d'actionnement (2) ne se modifient pas.

3. Le dispositif (1) de surveillance fonctionnelle selon une des revendications 1 ou 2, le signal à la sortie de commutation (11) du moyen de commutation de sécurité (5) se modifiant du fait de la modification du signal à la sortie d'actionnement (9).

4. Le dispositif (1) de surveillance fonctionnelle selon une des revendications 1 à 3, le moyen d'analyse (3) comportant une entrée de test (18).

5. Le dispositif (1) de surveillance fonctionnelle selon la revendication 4, le signal avec l'information sur la modification du signal à la sortie de commutation (11) étant fourni à la sortie de message fonctionnel (16) au moins tant qu'un signal est fourni à l'entrée de test (18) du moyen d'analyse (3).

6. Le dispositif (1) de surveillance fonctionnelle selon une des revendications 1 à 5, le moyen d'actionnement (2) étant conçu pour modifier le signal à la sortie de commutation (11) du moyen de commutation de sécurité (5) en réaction à un signal à l'entrée de commande (7).

7. Le dispositif (1) de surveillance fonctionnelle selon une des revendications 1 à 6, le moyen d'analyse (3) comportant une entrée de commande (17), et le moyen d'analyse (3) étant conçu, après l'obtention d'un signal avec une information sur la modification du signal à la sortie de commutation (11) du moyen de commutation de sécurité (5), pour remettre à l'état initial les signaux à la sortie de retour (14) et à la sortie de message fonctionnel (16) en réaction à une modification du signal à l'entrée de commande (17) .

8. Le dispositif (1) de surveillance fonctionnelle selon une des revendications 1 à 7, le moyen d'actionnement (2) et le moyen d'analyse (3) réalisant le fonctionnement défini dans les revendications respectives avec une logique câblée.

9. Le dispositif (1) de surveillance fonctionnelle selon une des revendications 1 à 8, le moyen d'actionnement (2) étant réalisé avec des portes logiques et le moyen d'analyse (3) étant réalisé avec des bascules bistables (19, 20).

10. Le dispositif (1) de surveillance fonctionnelle selon une des revendications 1 à 9, comprenant en outre :
un moyen de commande (4) qui est relié à l'entrée de test (8) du moyen d'actionnement (2) et à la sortie de message fonctionnel (16) du moyen d'analyse (3).

11. Le dispositif (1) de surveillance fonctionnelle selon une des revendications 9 ou 10, le moyen de commande (4) étant conçu pour déclencher un test fonctionnel à intervalles périodiques.

12. Le dispositif (1) de surveillance fonctionnelle selon la revendication 11, le moyen de commande (4) déclenchant le test fonctionnel en modifiant le signal à l'entrée de test (8) et à l'entrée de commande (7) du moyen d'actionnement (2).

13. Le dispositif (1) de surveillance fonctionnelle selon une des revendications 11 ou 12, l'intervalle périodique étant compris entre 5 millisecondes et 15 minutes.

14. Le dispositif (1) de surveillance fonctionnelle selon une des revendications 9 à 13, le moyen de commande (4) contenant une logique programmable.

15. Un procédé de surveillance fonctionnelle d'un moyen de commutation de sécurité (5) qui peut être utilisé en particulier pour commuter un actionneur (6), le procédé consistant à :
modifier un signal à une sortie d'actionnement (9) d'un moyen d'actionnement (2), laquelle est reliée à une entrée d'actionnement (10) du moyen de commutation de sécurité (5), en fonction d'un signal à une entrée de test (8) et à une entrée de commande (7) du moyen d'actionnement (2), le moyen de commutation de sécurité (5) étant commuté dans un mode de fonctionnement à l'aide d'un signal à l'entrée de commande (7), et un test fonctionnel étant déclenché à l'aide d'un signal à l'entrée de test (8) ;
détecter sur un moyen d'analyse (3) une modification d'un signal à une sortie de commutation (11) du moyen de commutation de sécurité (5) ;
fournir à une sortie de message fonctionnel (16) du moyen d'analyse (3) un signal avec une information sur la modification du signal à la sortie de commutation (11) du moyen de commutation de sécurité (5) et transmettre le signal avec l'information, sur la modification du signal à une entrée de retour (13) du moyen d'actionnement (2) ; et
annuler la -modification de signal à la sortie d'actionnement (9) du moyen d'actionnement (2) en cas de test fonctionnel en fonction de l'obtention du signal avec l'information sur la modification.
